# EUROPÄISCHE PATENTSCHRIFT

(11) **EP 3 862 550 B1**
(45) Veröffentlichungstag und Bekanntmachung des Hinweises auf die Patenterteilung: **13.12.2023**
(21) Anmeldenummer: 21166369.5
(22) Anmeldetag: 30.08.2018
(51) Int. Cl.: F02C 7/052, F02C 7/055, B01D 46/44, F04D 29/70, B01D 46/10

(54) **AUSLEGUNG, STEUERUNG UND BETREIBEN VON FILTERN FÜR TURBOMASCHINEN**
DESIGN, CONTROL AND OPERATION OF FILTERS FOR TURBOMACHINES
CONCEPTION, COMMANDE ET FONCTIONNEMENT DES FILTRES POUR TURBOMACHINES

(43) Veröffentlichungstag der Anmeldung: 11.08.2021
(62) Teilanmeldung aus: 18191594.3
(73) Patentinhaber: Carl Freudenberg KG, 69469 Weinheim (DE)
(72) Erfinder: Hirsch, Georg, 76698 Ubstadt-Weiher (DE); Weber, Patrick, 69469 Weinheim (DE); Schroth, Thomas, 67240 Bobenheim-Roxheim (DE)

(56) Entgegenhaltungen:
- EP-A1- 3 121 414
- EP-A1- 3 121 415
- EP-A1- 3 293 367

## Beschreibung

Die Erfindung betrifft ein Verfahren zum Betreiben einer Filteranordnung für die Luftzufuhr einer Turbomaschine, wie beispielsweise einer Gasturbine oder eines Kompressors.

### Stand der Technik

Die Funktion von Gasturbinen, Kompressoren und anderen Turbomaschinen, in denen Luft verdichtet wird, kann durch Partikel in der zugeführten Luft beeinträchtigt werden. Viele Arten von Partikeln können sich mit der Zeit in der Turbomaschine anlagern (Fouling) und so die Aerodynamik von Turbinenschaufeln verändern, wodurch der Wirkungsgrad verschlechtert wird und eine regelmäßige Reinigung der Turbomaschine nötig wird. Bestimmte Arten von Partikeln können auch durch mechanische Erosion, und/oder durch chemische Korrosion, direkt Schäden an den Turbinenschaufeln verursachen. Die Broschüre "Zuluftfiltration" der Arbeitsgemeinschaft für sparsamen und umweltfreundlichen Energieverbrauch e.V. (1991) beschreibt das Problem im Detail und zeigt auf, wie sich durch die geeignete Auslegung einer Filterung für die der Turbomaschine zugeführte Luft die Standzeit und der Wirkungsgrad der Turbomaschine verbessern lassen.

(U. Schirmeister, F. Mohr, "Impact of Enhanced GT Air Filtration on Power Output and Compressor Efficiency Degradation", Proceedings of ASME Turbo Expo 2016, 13.-17.06.2016, Seoul, Südkorea) offenbart, dass eine Zuluftfiltration ihrerseits einen Druckverlust in der Luftzufuhr zur Turbomaschine bewirkt und somit die Leistung der Turbomaschine vermindert. Somit ist der Filter mit der besten Abscheidung von Partikeln nicht automatisch auch aus wirtschaftlicher Sicht der optimale Filter.

EP 3 121 414 A1 und EP 3 121 415 A1 offenbaren ein Triebwerk für ein Luftfahrzeug mit einem Luftfilter, dessen Wirkung mit einem Verschlussmechanismus ein- und ausschaltbar ist.

### Aufgabe und Lösung

Es ist daher die Aufgabe der Erfindung, die Auslegung und/oder Steuerung von Filtern für die Luftzufuhr von Turbomaschinen zu systematisieren und zugleich zu automatisieren.

Diese Aufgabe wird erfindungsgemäß gelöst durch ein Verfahren gemäß Hauptanspruch sowie durch ein Computerprogramm gemäß Nebenanspruch. Weitere vorteilhafte Ausgestaltungen ergeben sich aus den darauf rückbezogenen Unteransprüchen.

### Offenbarung der Erfindung

Im Rahmen der Erfindung wurde ein Verfahren zur Auslegung und/oder Steuerung einer Filteranordnung für die Luftzufuhr zu einer Turbomaschine entwickelt.

Bei diesem Verfahren wird eine gegenwärtige, und/oder eine zu erwartende, Konzentration n(d) von Partikeln in der am Eingang mindestens einer Filterstufe der Filteranordnung vorliegenden Luft als Funktion der mittleren Größe d der Partikel ermittelt.

Diese Information kann auf beliebigem Wege erhalten werden. Es können beispielsweise im Rahmen der Auslegung der Filteranordnung Messungen an der Umgebungsluft am Ort der Turbomaschine, d.h. am beabsichtigten Verwendungsort der Filteranordnung, durchgeführt werden. Ebenso kann eine gegenwärtige, und/oder zu erwartende, Konzentration von Partikeln in der Umgebungsluft der Filteranordnung von einer externen Datenquelle bezogen werden, wie beispielsweise von einem Wetterdienst oder einer Umweltbehörde.

Es wird ein Sensitivitätsspektrum S(d) ermittelt, das in Abhängigkeit der mittleren Größe d der Partikel angibt, in welchem Maße sich eine gegebene Konzentration dieser Partikel negativ auf die Leistung, und/oder auf die Lebensdauer, der Turbomaschine auswirkt. Dieses Sensitivitätsspektrum basiert auf einer großen Datenmenge von Erfahrungswerten, wobei Leistungsdaten von Turbomaschinen mit vorliegenden Konzentration n(d) von Partikeln am Eingang der Turbomaschine korreliert werden.

Es wurde erkannt, dass die Anfälligkeit einer konkreten Turbomaschine für eine Beeinträchtigung des Betriebs, oder gar für eine Schädigung, durch angesaugte Partikel zum einen von mittleren Größe der Partikel abhängt und zum anderen auch in hohem Maße für die konkrete Turbomaschine spezifisch ist. So sind beispielsweise Turbinenschaufeln vielfach mit dünnen Funktionsschichten, etwa Wärmedämmschichten, vergütet. Diese Schichten werden bei einem Erosionsangriff wesentlich schneller zerstört als das dicke Grundmaterial. Die Zerstörung der Wärmedämmschicht hat aber im Betrieb unmittelbar das Versagen auch des dann ungeschützt der hohen Verbrennungstemperatur ausgesetzten Grundmaterials zur Folge. Daher ist eine Beaufschlagung mit größeren Partikeln, die eine Erosion verursachen können, zu vermeiden.

Auch ist beispielsweise die Anfälligkeit für die Anlagerung von Partikeln (Fouling) in hohem Maße von der Geometrie und auch vom Material der Turbinenschaufeln abhängig.

Schließlich ist die Anfälligkeit für chemische Korrosion von Turbinenschaufeln von der chemischen Zusammensetzung der Partikel abhängig, die wiederum mit der mittleren Größe d der Partikel korreliert ist.

Das Sensitivitätsspektrum erfüllt somit eine ähnliche Funktion wie die Bewertung der biologischen Wirksamkeit in der Äquivalentdosis für ionisierende Strahlung. Dort kann je nach Strahlungsart die Wirksamkeit ein und derselben Energiedosis um einen Faktor von 20 variieren. Die mittlere Größe d der Partikel erfüllt in dieser Analogie die Funktion der Strahlungsart.

Wenn nun eine konkrete Turbomaschine für Beeinträchtigungen durch Partikel in einem bestimmten Größenbereich anfällig ist, so treten diese Beeinträchtigungen nur dann ein, wenn solche Partikel auch tatsächlich in der zugeführten Luft enthalten sind. Der konkrete Bedarf nach Art und Stärke der Luftfiltration wird also in einem Zusammenspiel aus den am Ort der Turbomaschine vorkommenden Partikelgrößen und der von der Partikelgröße abhängigen Anfälligkeit der konkreten Turbomaschine festgelegt.

So kann beispielsweise der Fall eintreten, dass nur ein Teil der am Ort der Turbomaschine vorkommenden Partikelgrößen in nennenswertem Umfang beeinträchtigend oder schädlich auf die Turbomaschine wirkt. Es genügt dann, nur diese Partikel auszufiltern. Alle anderen Partikel können von der Filteranordnung durchgelassen werden, was mehrere vorteilhafte Wirkungen hat. Die Filteranordnung ist preiswerter herzustellen und hat zugleich einen geringeren Strömungswiderstand, d.h., wenn sie im Betrieb der Turbomaschine durchströmt wird, ist der Druckverlust geringer. Schließlich sammeln sich insgesamt weniger Partikel in der Filteranordnung, so dass eine längere Betriebszeit möglich ist, bis der Filter ausgetauscht werden muss.

Daher wird für mindestens einen in der Filterstufe einsetzbaren, und/oder zu- oder abschaltbaren, Filter-Kandidaten aus der Konzentration n(d) und den Filtereigenschaften des Filter-Kandidaten die am Ausgang der Filterstufe zu erwartende Konzentration n'(d) der Partikel ermittelt. Aus der Konzentration n'(d) und dem Sensitivitätsspektrum S(d) wird ein Gütemaß ermittelt und dem Filter-Kandidaten, und/oder der Filteranordnung, zugeordnet.

Dieses Gütemaß kann in vielfältiger Weise verwendet werden. Beispielsweise kann bei der Auslegung der Filteranordnung eine Liste möglicher Filteranordnungen nach Werten des Gütemaßes sortiert werden, um eine Vorauswahl zu treffen und die endgültige Auswahl der Filteranordnung, die noch weitere Kriterien umfasst, zu erleichtern. Das Gütemaß kann auch beispielsweise verwendet werden, um mit einem automatisierten Optimierungsverfahren, wie beispielsweise mit einem Gradientenabstiegsverfahren, eine im Hinblick auf das Gütemaß optimale Filteranordnung zu finden. Ein solches Optimum in einem manuellen Prozess zu finden ist nicht praktikabel, da der Katalog der verfügbaren Filter je nach Anwendungsbereich zwischen 2.000 und 20.000 Filter umfasst und bei einem mehrstufigen Filter die Zahl der möglichen Kombinationen ausufert.

Die automatisierte Bewertung der Filteranordnungen kann auf der Basis der bekannten Gesetze der Strömungsmechanik erfolgen. Die Abscheiderate eines jeden Filters in Abhängigkeit der mittleren Größe d der Partikel und auch der Anströmgeschwindigkeit wird standardmäßig detailliert untersucht, wenn der Filter in Verkehr gebracht wird. Es sind also für jeden in Frage kommenden Filter die zur Berechnung der hinter dem Filter zu erwartenden Konzentration n'(d) der Partikel verfügbar.

Das Gütemaß kann aber auch beispielsweise verwendet werden, um die Filteranordnung online zu steuern. So kann sich beispielsweise die größenabhängige Konzentration n(d) der Partikel, die am Eingang der Filterstufe vorliegt, abhängig von der Wetterlage oder von der Jahreszeit ändern. Es kann dann beispielsweise sinnvoll sein, einzelne Filterstufen nach Bedarf zu aktivieren oder zu deaktivieren, bzw. die Ansteuerung eines elektrisch betriebenen Filters zu ändern. So tritt beispielsweise zu bestimmten Jahreszeiten vermehrt Pollenflug auf, der aber wiederum deutlich abgeschwächt ist, wenn es regnet.

Unabhängig davon, ob das Verfahren zur Vorab-Auslegung oder zur Online-Steuerung der Filteranordnung genutzt wird, ist der Effekt gleich: Das Abscheiden von Partikeln kann auf diejenigen Partikel konzentriert werden, die für den Betrieb, bzw. für die Lebensdauer, am meisten störend sind. Hingegen lässt die Filteranordnung Partikel, die die Turbomaschine problemlos toleriert, ungehindert passieren. Somit entsteht in der Filteranordnung keine unnötige Ansammlung dieser Partikel, die irgendwann entfernt werden muss, und es wird kein unnötiger Strömungswiderstand in die Luftzufuhr eingebracht. Der durch die Filteranordnung bewirkte Druckverlust ist also auf das Nötige beschränkt.

In einer besonders vorteilhaften Ausgestaltung wird zur Ermittlung der am Ausgang der Filterstufe zu erwartenden Konzentration n'(d) der Partikel zusätzlich der Druck p der Luft am Eingang der Filterstufe in Abhängigkeit der mittleren Größe d der Partikel herangezogen. Auf diese Weise kann berücksichtigt werden, dass die Filterleistung ein und desselben Filters für ein und dieselbe mittlere Größe d der Partikel von der Anströmgeschwindigkeit am Eingang des Filters abhängt. So ist beispielsweise bei geringen Anströmgeschwindigkeiten der Transport der Partikel durch Diffusion bevorzugt, während in einem bestimmten Geschwindigkeitsbereich Trägheitskräfte zu einer erhöhten Abscheidung der Partikel im Filter führen. Der Druck p kann auch einen Staudruck beinhalten, der durch das Anströmen der Filterstufe zu Stande kommt.

Daher wird in einer weiteren besonders vorteilhaften Ausgestaltung zusätzlich zur zu erwartenden Konzentration n'(d) der Partikel am Ausgang der Filterstufe auch der zu erwartende Druck p' der Luft am Ausgang der Filterstufe ermittelt. Aus dem Druck p' am Ausgang einer jeden Filterstufe geht in Verbindung mit der Konzentration n'(d) am Ausgang der jeweiligen Filterstufe des Weiteren der von der mittleren Größe d der Partikel abhängige Mengenstrom an Partikeln hervor, der die Filterstufe verlässt. Hier ist insbesondere der Mengenstrom an Partikeln wichtig, der die letzte Filterstufe verlässt und somit in die Turbomaschine eintritt. So kann beispielsweise die erforderliche Filterleistung der Filteranordnung in Form eines maximal zulässigen Mengenstroms an Partikeln spezifiziert sein. Die Motivation einer solchen Spezifikation kann beispielsweise darin bestehen, dass die innerhalb eines Intervalls zwischen zwei Reinigungen oder Wartungen der Turbomaschine insgesamt angesaugten Partikel nur ein bestimmtes Maß an Fouling oder an Beschädigung hervorrufen dürfen. Insbesondere kann die Druckdifferenz zwischen dem Druck p am Eingang einer Filterstufe und dem Druck p' am Ausgang dieser Filterstufe aus einer Datenbank abgerufen werden, da sie eine der wichtige Kenngrößen für einen Filter ist und dementsprechend für jeden am Markt verfügbaren Filter mit einem normierten Verfahren gemessen wird.

In einer weiteren besonders vorteilhaften Ausgestaltung hängen das Sensitivitätsspektrum S(d, M), und/oder die Konzentration n(d, M), n'(d, M), zusätzlich auch vom Material M der Partikel, d.h. von der chemischen Zusammensetzung der Partikel, ab. Wenn auf diese Weise berücksichtigt wird, dass die Wechselwirkung der Partikel mit dem Filter, bzw. mit der Turbomaschine, materialabhängig ist, dann kann die Abscheidung im Filter, bzw. die beeinträchtigende Wirkung durchgelassener Partikel auf die Turbomaschine, genauer bestimmt werden. So verursachen beispielsweise harte Partikel, wie Sandkörner, mehr Erosion in der Turbomaschine, während reaktive Partikel, wie Salzkristalle, stärker zu Korrosion in der Turbomaschine beitragen. Im Filter wird ein Partikel dann abgeschieden, wenn es durch eine physikalische Kraftwirkung, wie etwa eine elektrostatische Kraft oder eine Vander-Waals-Kraft, an das Filtermaterial gebunden wird. Diese Kraftwirkungen sind materialabhängig.

Vorteilhaft wird eine Filteranordnung aus mehreren in Strömungsrichtung der Luft hintereinander geschalteten Stufen gewählt. Wie zuvor erläutert, können dann insbesondere die Wechselwirkungen zwischen den Filterstufen berücksichtigt werden, die sich daraus ergeben, dass eine jede Filterstufe durch ihren Strömungswiderstand eine Druckdifferenz erzeugt.

Vorteilhaft wird die Filteranordnung so aus einem oder mehreren Filter-Kandidaten gebildet, dass der Strömungswiderstand der Filteranordnung optimiert wird unter einer vorgegebenen Randbedingung für das Gütemaß. Je geringer der Strömungswiderstand ist, desto geringer ist auch der Druckverlust und desto besser ist der Wirkungsgrad der Turbomaschine. Zugleich bewirkt die Anwesenheit von nur der benötigten Menge an Filtermaterial in der Luftzufuhr, dass sich darin auch nur die nötige Menge an Partikeln ablagert. Dies zögert den unvermeidlichen Zeitpunkt hinaus, zu dem die Aufnahmekapazität des Filters erschöpft ist und der Filter ersetzt werden muss.

Daher wird in einer weiteren vorteilhaften Ausgestaltung die Optimierung unter einer zusätzlichen Randbedingung bezüglich der Standzeit mindestens einer Filterstufe durchgeführt. Auf diese Weise kann auch eine angemessene Kompromisslösung für einen Zielkonflikt zwischen dieser Standzeit, der Leistung der Turbomaschine und der Lebensdauer der Turbomaschine erhalten werden. Ist der Filter wirksamer, wird die Leistung der Turbomaschine durch den erhöhten Strömungswiderstand vermindert. Dafür wird die Lebensdauer der Turbomaschine erhöht und der Wartungsaufwand vermindert, da weniger Partikel auf sie einwirken. Dies wird aber wiederum damit erkauft, dass der Filter eher voll ist und ersetzt werden muss. Ein weniger wirksamer Filter ist später voll, und durch den geringeren Strömungswiderstand liefert die Turbomaschine mehr Leistung im Hier und Jetzt. Dafür muss sie früher gereinigt oder gewartet werden, da mehr Partikel hineingelangen.

Aus den vorstehenden Überlegungen folgt, dass die Erfindung sich losgelöst von der Vorab-Auslegung allgemein auch auf ein Verfahren zum Betreiben einer Filteranordnung für die Luftzufuhr zu einer Turbomaschine bezieht.

Bei diesem Verfahren wird eine gegenwärtige, und/oder eine zu erwartende, Konzentration n(d) von Partikeln in der am Eingang mindestens einer Filterstufe vorliegenden Luft als Funktion der mittleren Größe d der Partikel ermittelt. Für mindestens einen in der Filterstufe vorhandenen Filter wird aus der Konzentration n(d) und den Filtereigenschaften des Filters die am Ausgang der Filterstufe zu erwartende Konzentration n'(d) der Partikel ermittelt. Aus dem Druck p der Luft am Eingang der Filterstufe und den Filtereigenschaften des Filters wird der zu erwartende Druck p' der Luft am Ausgang der Filterstufe ermittelt. Es wird ein Sensitivitätsspektrum S(d) ermittelt, das in Abhängigkeit der mittleren Größe d der Partikel angibt, in welchem Maße sich eine gegebene Konzentration dieser Partikel negativ auf die Leistung, und/oder auf die Lebensdauer, der Turbomaschine auswirkt.

Aus der Konzentration n'(d) der Partikel, dem Druck p' der Luft am Ausgang der Filterstufe und dem Sensitivitätsspektrum S(d) wird ein Leistungsverlust L der Turbomaschine ermittelt.

Dieser Leistungsverlust L kann beispielsweise an die Menge Q an Partikeln, die in die Turbomaschine eintritt, gekoppelt sein. Aus der Konzentration n'(d) und dem Druck p' ergibt sich ein Mengenstrom, und Integration über die Zeit liefert die Menge Q. Es wurde erkannt, dass beispielsweise der Verlust an Wirkungsgrad der Turbomaschine in Folge von Fouling insbesondere von der Gesamtmenge der in der Turbomaschine abgelagerten Partikel abhängt. Auch das Ausmaß von Schäden beispielsweise durch Erosion und/oder Korrosion kann maßgeblich von der Gesamtdosis an Partikeln seit der letzten Wartung bestimmt werden. Somit umfasst die Ermittlung des Leistungsverlusts L vorteilhaft die Ermittlung der Menge Q an Partikeln, die in die Turbomaschine eintritt.

Wenn der Leistungsverlust L bestimmt wird, dann kann der Zeitpunkt, zu dem eine Reinigung oder Wartung der Turbomaschine nötig ist, zustandsabhängig bestimmt werden. Es ist nicht mehr zwangsläufig nötig, diese Reinigung oder Wartung nach einem festen Turnus an Betriebsstunden vorzunehmen, wobei auf Grund der nötigen Sicherheitszuschläge immer ein gewisses Maß an verbleibender Betriebsdauer "verschenkt" wird.

Daher wird in einer besonders vorteilhaften Ausgestaltung in Antwort darauf, dass der Leistungsverlust L einen vorgegebenen Schwellwert überschreitet, ein Online-Waschvorgang der Turbomaschine ausgelöst, und/oder es wird eine Wartung der Turbomaschine angefordert.

Wie eingangs bereits erwähnt, muss die Konzentration n(d) von Partikeln am Eingang der Filterstufe nicht statisch sein, sondern kann sich beispielsweise jahreszeitlich oder auf Grund der Wetterlage ändern. Daher bezieht sich die Erfindung auch allgemein auf ein Verfahren zum Betreiben einer Filteranordnung für die Luftzufuhr zu einer Turbomaschine. Bei diesem Verfahren werden die Wirkstärke, Z und vorzugsweise der Filtertyp, mindestens einer Filterstufe der Filteranordnung einer Änderung der gegenwärtigen, und/oder zu erwartenden, Konzentration n(d) von Partikeln am Eingang dieser Filterstufe nachgeführt.

Dabei kann der Effekt dieses Nachführens auf die am Ausgang der Filterstufe zu erwartende Konzentration n'(d) der Partikel, und/oder auf den am Ausgang der Filterstufe zu erwartenden Druck p' an Luft, insbesondere in analoger Weise bestimmt werden wie zuvor für das Verfahren zur Auslegung und/oder Steuerung einer Filteranordnung beschrieben. Der diesbezügliche Offenbarungsumfang ist also vollumfänglich für das Verfahren zum Betreiben verwendbar.

Wie zuvor bereits angedeutet, kann hierdurch die Zuluftfiltration für die Turbomaschine dem tatsächlichen Bedarf angepasst werden. Ist beispielsweise die Umgebungsluft nach heftigen Regenfällen sehr sauber, so kann eine deutlich schwächere Filterung eingestellt werden, die einen größeren Massenstrom von Luft zur Turbomaschine durchlässt. Ebenso kann beispielsweise ein speziell für Pollen oder Saharastaub vorgesehener Filter genau dann zugeschaltet werden, wenn tatsächlich mit derartigen Partikeln in der Umgebungsluft zu rechnen ist. Derartige Spezialfilter werden dann zum einen nicht unnötig verschmutzt und tragen zum anderen nicht ständig zum Strömungswiderstand der Filteranordnung bei.

Beispielsweise kann die Wirkstärke der Filterstufe angepasst werden, indem der wirksame Strömungsquerschnitt einer die Filterstufe umgehenden Bypassleitung erhöht oder erniedrigt wird. Hierfür kann beispielsweise ein Wegeventil oder ein Proportionalventil genutzt werden.

Gemäß der Erfindung wird eine Filterstufe mit einem Filter gewählt, dessen Wirkung durch das Anlegen einer elektrischen Spannung an den Filter, und/oder durch das Treiben eines elektrischen Stroms durch den Filter, aktivierbar ist. Die Wirkstärke der Filterstufe wird dann angepasst, indem die elektrische Spannung, und/oder der elektrische Strom, erhöht oder erniedrigt wird. Ein Beispiel hierfür sind Elektrofilter, in denen Staubpartikel über Sprühelektroden aufgeladen werden, damit sie sich anschließend an Abscheideelektroden niederschlagen.

In allen beschriebenen Verfahren kann vorteilhaft die gegenwärtige Konzentration n(d) von Partikeln am Eingang der Filterstufe aus einer Messung der Konzentration von Partikeln in der Umgebungsluft der Filteranordnung ermittelt werden. Dann kann besonders zeitnah auf eine Änderung, beispielsweise auf eine Abnahme als Folge eines Regenschauers oder auf eine Zunahme durch Bauarbeiten in der Nähe der Turbomaschine, reagiert werden. Weiterhin kann in allen beschriebenen Verfahren eine gegenwärtige, und/oder zu erwartende, Konzentration von Partikeln in der Umgebungsluft der Filteranordnung von einer externen Datenquelle bezogen und zur Ermittlung der gegenwärtigen, und/oder zu erwartenden, Konzentration n(d) von Partikeln am Eingang der Filterstufe herangezogen werden. Beispielsweise kann mit Hilfe von Wetterdaten eines Wetterdienstes vorhergesagt werden, dass Regen niedergehen wird oder dass Saharastaub zum Ort der Turbomaschine geweht werden wird.

Die beschriebenen Verfahren können insbesondere ganz oder teilweise computergesteuert ablaufen. Entsprechende Software kann insbesondere beispielsweise als Update oder Upgrade für bestehende Auslegungs- oder Steuersoftware vertrieben werden und ist insofern ein eigenständiges Produkt. Daher bezieht sich die Erfindung auch auf ein Computerprogramm mit maschinenlesbaren Anweisungen, die, wenn sie auf einem Computer, und/oder auf einem Steuergerät, und/oder auf einem Embedded-System, ausgeführt werden, den Computer, das Steuergerät, bzw. das Embedded-System, dazu veranlassen, eines oder mehrere der beschriebenen Verfahren auszuführen. Ebenso bezieht sich die Erfindung auch auf einen maschinenlesbaren Datenträger oder ein Downloadprodukt mit dem Computerprogramm.

Die Verfahren sind insbesondere beispielsweise an Gasturbinen und Kompressoren als Turbomaschinen anwendbar, jedoch hierauf nicht beschränkt.

### Spezieller Beschreibungsteil

Nachfolgend wird der Gegenstand der Erfindung anhand von Figuren erläutert, ohne dass der Gegenstand der Erfindung hierdurch beschränkt wird. Es ist gezeigt:
Figur 1: Beispielhafte Wirkung einer Filteranordnung 1 vor einer Luftzufuhr 2 zu einer Turbomaschine 3;
Figur 2: Ausführungsbeispiel des Verfahrens 100 zur Ansteuerung und/oder Auslegung einer Filteranordnung 1;
Figur 3: Ausführungsbeispiel des Verfahrens 200 zum Betreiben einer Filteranordnung 1;
Figur 4: Ausführungsbeispiel des Verfahrens 300 zum Betreiben einer Filteranordnung 1.

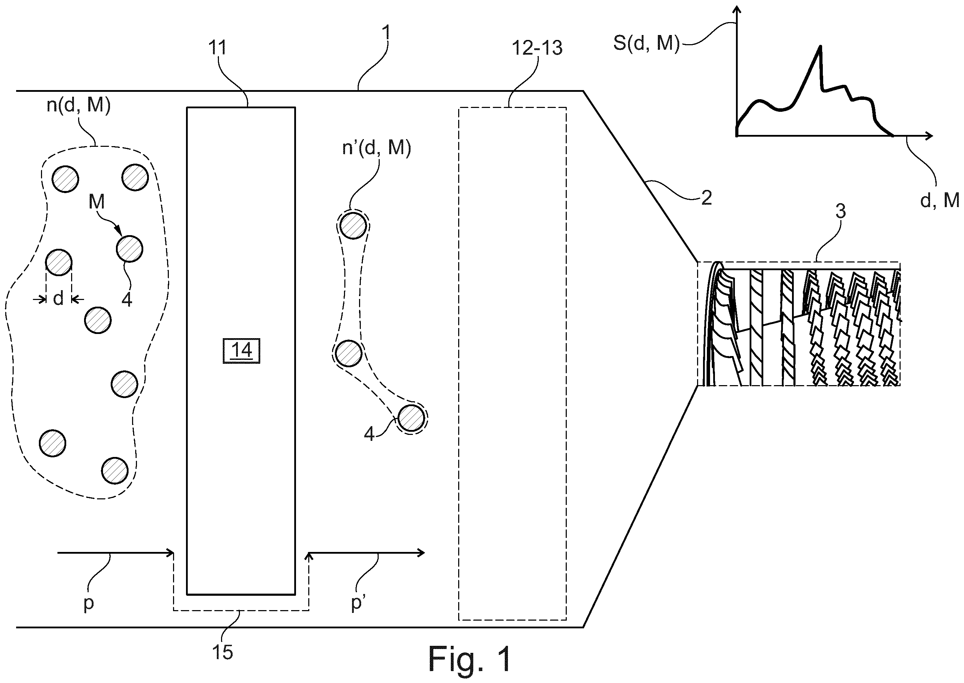

Figur 1 zeigt schematisch die Wirkung einer Filteranordnung 1, die vor einer Luftzufuhr 2 zu einer Turbomaschine 3 angeordnet ist, und verdeutlicht die beteiligten Größen.

Die Filteranordnung 1 enthält hintereinander geschaltete Filterstufen 11-13. Der Übersichtlichkeit halber ist in Figur 1 nur die Wirkung der ersten Filterstufe 11 näher dargestellt, während das Vorhandensein der anderen Filterstufen 12, 13 lediglich angedeutet ist.

Die Turbomaschine 3 saugt Luft an, die vor der ersten Filterstufe 11 einen Druck p hat. Die Filterstufe 11 bewirkt einen Druckverlust hin zu einem geringeren Druck p'. Aufgabe der Filterstufe 11 ist es, Partikel 4 aus der Luft herauszufiltern. Jedes Partikel 4 hat eine Größe d und besteht aus dem Material M. Die Partikel 4 liegen vor der Filterstufe 11 in einer Konzentration n(d, M) vor, die sowohl von der mittleren Größe d als auch vom Material M der Partikel 4 abhängt. Diese Konzentration n(d, M) wird durch die Filterstufe 11 zu einer Konzentration n'(d, M) vermindert.

Bei der Auslegung der Filteranordnung 1 können insbesondere verschiedene Filter-Kandidaten 14 für die Filterstufe 11 getestet und mit einem in Figur 1 nicht eingezeichneten Gütemaß 14a dahingehend bewertet werden, wie gut die jeweilige Filterleistung zu den Erfordernissen der Turbomaschine 3 passt.

Die Anforderungen der Turbomaschine 3 an die Filterleistung stecken in dem Sensitivitätsspektrum S(d, M), das angibt, wie störend sich Partikel 4 mit einer mittleren Größe d, die aus dem Material M bestehen, jeweils auf den Betrieb, bzw. die Lebensdauer, der Turbomaschine 3 auswirken. Das entsprechende Diagramm in Figur 1 ist der Übersichtlichkeit halber zweidimensional gezeichnet. Es müsste eigentlich ein dreidimensionales Gebirge sein, dessen Höhe S(d, M) von den Koordinaten d und M abhängt.

In Figur 1 ist angedeutet, dass die Filterstufe 11 durch eine Bypassleitung 15 überbrückt werden kann. Damit kann beispielsweise die Filterleistung an eine sich ändernde Konzentration n(d, M) der Partikel 4 in der Zuluft angepasst werden.

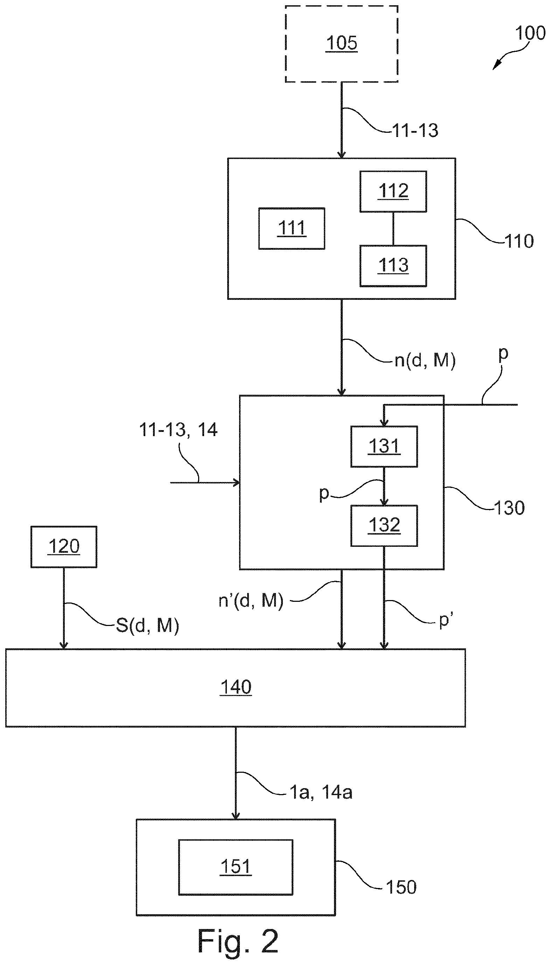

Figur 2 zeigt ein Ausführungsbeispiel des Verfahrens 100 zur Auslegung und/oder Steuerung der Filteranordnung 1. In dem optionalen Schritt 105 wird eine Filteranordnung 1 aus mehreren Filterstufen 11-13 gewählt.

In Schritt 110 wird die Konzentration n(d, M) der Partikel 4 am Eingang mindestens einer Filterstufe 11-13 bestimmt. Dies kann gemäß Block 111 durch direkte Messung geschehen. Alternativ oder in Kombination kann gemäß Block 112 eine Partikelkonzentration in der Umgebungsluft aus einer externen Datenquelle abgerufen und gemäß Block 112 herangezogen werden, um die Konzentration n(d, M) zu ermitteln.

In Schritt 130 wird die zu erwartende Partikelkonzentration n'(d, M) am Ausgang der Filterstufe 11-13 bestimmt. Dabei kann insbesondere gemäß Block 131 zusätzlich auch der Druck p der Luft am Eingang der Filterstufe herangezogen werden, und gemäß Block 132 kann zusätzlich der zu erwartende Druck p' am Ausgang der Filterstufe 11-13 ermittelt werden.

Unabhängig hiervon wird in Schritt 120 das Sensitivitätsspektrum S(d, M) der Turbomaschine 3 gegenüber den Partikeln 4 ermittelt. Aus diesem Sensitivitätsspektrum S(d, M) in Verbindung mit der verbleibenden Konzentration n'(d, M) an Partikeln und dem Druck p' am Ausgang der Filterstufe 11-13 wird in Schritt 140 ein Gütemaß 14a für den aktuell in der Filterstufe 11-13 eingesetzten Filter-Kandidaten 14, bzw. ein Gütemaß 1a für die Filteranordnung 1 als Ganzes, ermittelt. In Schritt 150 können nun solche Filter-Kandidaten 14 gefunden werden, die den Strömungswiderstand der Filteranordnung 1 optimieren unter Einhaltung einer vorgegebenen Randbedingung für das Gütemaß 1a, 14a. Gemäß Block 151 kann die Standzeit mindestens einer Filterstufe 11-13 eine weitere Randbedingung bilden.

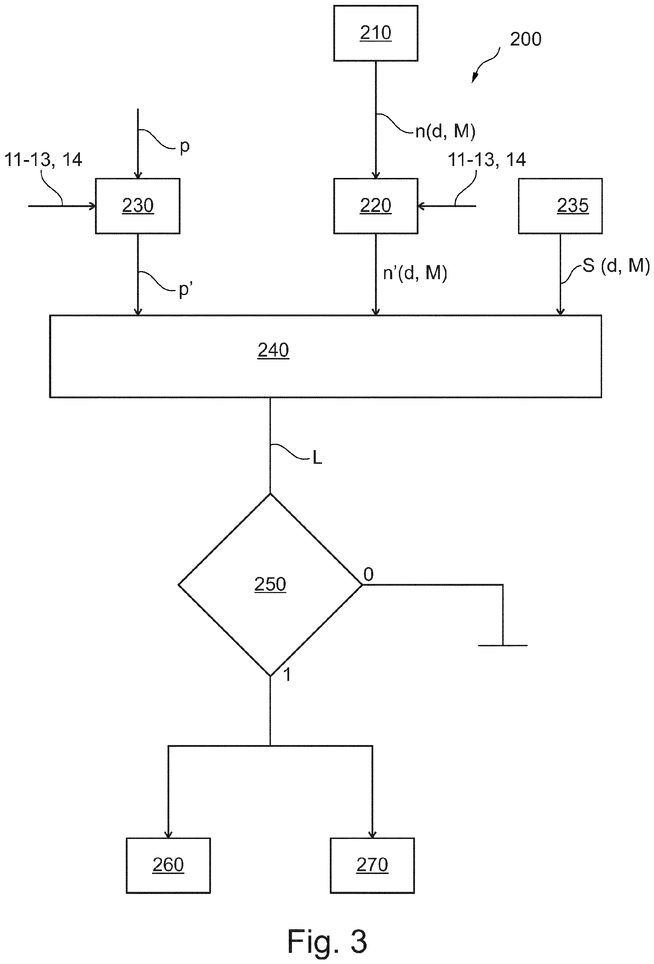

Figur 3 zeigt ein Ausführungsbeispiel des Verfahrens 200 zum Betreiben einer Filteranordnung 1. In Schritt 210 wird die Konzentration n(d, M) der Partikel 4 am Eingang mindestens einer Filterstufe 11-13 ermittelt. In Schritt 220 wird die am Ausgang der Filterstufe 11-13 zu erwartende Konzentration n'(d, M) der Partikel 4 ermittelt. Weiterhin wird in Schritt 230 der Druckverlust vom eingangsseitigen Druck p zum ausgangsseitigen Druck p' ermittelt. In Schritt 235 wird das Sensitivitätsspektrum S(d) ermittelt, das in Abhängigkeit der mittleren Größe d der Partikel 4 angibt, in welchem Maße sich eine gegebene Konzentration dieser Partikel 4 negativ auf die Leistung, und/oder auf die Lebensdauer, der Turbomaschine 3 auswirkt. In Schritt 240 wird aus der Konzentration n'(d, M), dem ausgangsseitigen Druck p' sowie dem Sensitivitätsspektrum S(d) der Leistungsverlust L.

In Schritt 250 wird geprüft, ob der Leistungsverlust L einen vorgegebenen Schwellwert überschreitet. Wird der Schwellwert nicht überschritten (Wahrheitswert 0), ist nichts zu tun. Wird der Schwellwert überschritten (Wahrheitswert 1), wird in Schritt 260 ein Online-Waschvorgang der Turbomaschine 3 ausgelöst, und/oder es wird in Schritt 270 eine Wartung der Turbomaschine 3 angefordert.

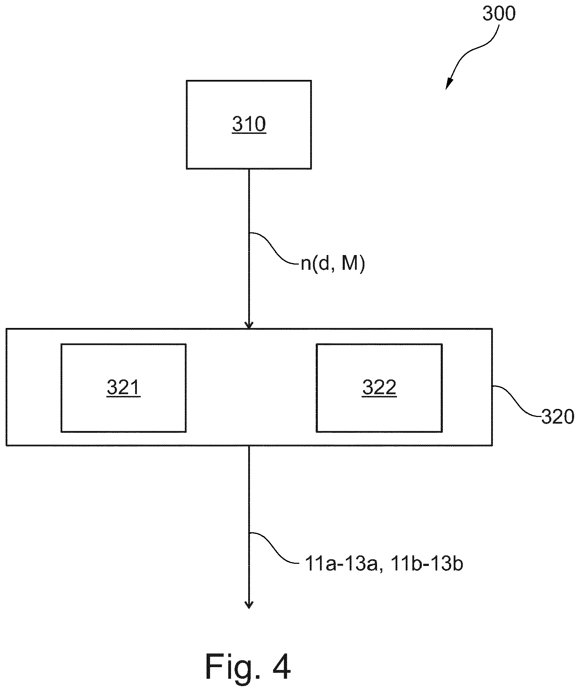

Figur 4 zeigt ein Ausführungsbeispiel des Verfahrens 300 zum Betreiben einer Filteranordnung 1. In Schritt 310 wird die Änderung der gegenwärtigen, und/oder zu erwartenden, Konzentration n(d, M) der Partikel am Eingang der Filterstufe 11-13 erkannt. In Schritt 320 wird hierauf durch eine Anpassung der Wirkstärke 11a-13a, und/oder des Filtertyps 11b-13b, der Filterstufe 11-13 reagiert. Gemäß Block 321 kann hierzu der wirksame Strömungsquerschnitt der Bypassleitung 15 verändert werden, etwa durch Öffnen oder Schließen eines Ventils. Gemäß Block 322 kann die elektrische Ansteuerung der Filterstufe 11-13 geändert werden.

## Patentansprüche

1. Verfahren (300) zum Betreiben einer Filteranordnung (1) für die Luftzufuhr (2) zu einer Turbomaschine (3), wobei die Wirkstärke (11a-13a), und vorzugsweise der Filtertyp (11b-13b), mindestens einer Filterstufe (11-13) der Filteranordnung (1) einer Änderung (310) der gegenwärtigen, und/oder zu erwartenden, Konzentration n(d) von Partikeln (4) am Eingang dieser Filterstufe (11) nachgeführt werden (320), **dadurch gekennzeichnet, dass** eine Filterstufe (11-13) mit einem Filter gewählt wird, dessen Wirkung durch das Anlegen einer elektrischen Spannung an den Filter, und/oder durch das Treiben eines elektrischen Stroms durch den Filter, aktivierbar ist, und dass die Wirkstärke (11a-13a) der Filterstufe angepasst wird (320), indem die elektrische Spannung, und/oder der elektrische Strom, erhöht oder erniedrigt wird (322).

2. Verfahren (300) nach Anspruch 1, wobei die Wirkstärke (11a-13a) der Filterstufe (11-13) angepasst wird (320), indem der wirksame Strömungsquerschnitt einer die Filterstufe (11-13) umgehenden Bypassleitung (15) erhöht oder erniedrigt wird (321).

3. Verfahren (100-300) nach einem der Ansprüche 1 bis 2, wobei die gegenwärtige Konzentration n(d) von Partikeln (4) am Eingang der Filterstufe (11-13) aus einer Messung der Konzentration von Partikeln (4) in der Umgebungsluft der Filteranordnung ermittelt wird (111).

4. Verfahren (100-300) nach einem der Ansprüche 1 bis 3, wobei eine gegenwärtige, und/oder zu erwartende, Konzentration von Partikeln (4) in der Umgebungsluft der Filteranordnung (1) von einer externen Datenquelle bezogen (112) und zur Ermittlung der gegenwärtigen, und/oder zu erwartenden, Konzentration n(d) von Partikeln (4) am Eingang der Filterstufe (11-13) herangezogen wird (113).

5. Computerprogramm, enthaltend maschinenlesbare Anweisungen, die, wenn sie auf einem Computer, und/oder auf einem Steuergerät, und/oder auf einem Embedded-System, ausgeführt werden, den Computer, das Steuergerät, bzw. das Embedded-System, dazu veranlassen, ein Verfahren (100-300) auf der Filteranordnung nach einem der Ansprüche 1 bis 4 auszuführen.

## Claims

1. Method (300) for operating a filter assembly (1) for the air supply (2) to a turbomachine (3), wherein the effectiveness (11a-13a) and preferably the filter type (11b-13b) of at least one filter stage (11-13) of the filter assembly (1) tracks (320) a change (310) in the current and/or to be expected concentration n(d) of particles (4) at the inlet to this filter stage (11), **characterized in that** a filter stage (11-13) with a filter the action of which can be activated by applying an electrical voltage to the filter and/or by driving an electrical current through the filter is chosen, and **in that** the effectiveness (11a-13a) of the filter stage is adjusted (320) by the electrical voltage and/or the electrical current being increased or reduced (322).

2. Method (300) according to Claim 1, wherein the effectiveness (11a-13a) of the filter stage (11-13) is adjusted (320) by the effective flow cross section of a bypass line (15) bypassing the filter stage (11-13) being increased or reduced (321).

3. Method (100-300) according to one of Claims 1 or 2, wherein the current concentration n(d) of particles (4) at the inlet to the filter stage (11-13) is determined (111) from a measurement of the concentration of particles (4) in the ambient air of the filter assembly.

4. Method (100-300) according to one of Claims 1 to 3, wherein a current and/or to be expected concentration of particles (4) in the ambient air of the filter assembly (1) is taken (112) from an external data source and is used (113) to determine the current and/or to be expected concentration n(d) of particles (4) at the inlet to the filter stage (11-13).

5. Computer program containing machine-readable instructions which, when they are executed on a computer and/or on a control device and/or on an embedded system, cause the computer, the control device or the embedded system to carry out a method (100-300) according to one of Claims 1 to 4 on the filter assembly.

## Revendications

1. Procédé (300) de fonctionnement d'un ensemble de filtration (1) destiné à l'alimentation en air (2) d'une turbomachine (3), l'efficacité (11a-13a), et de préférence le type de filtration (11b-13b), d'au moins un étage de filtration (11-13) de l'ensemble de filtration (1) étant asservis (320) à une variation (310) de la concentration actuelle et/ou attendue n(d) de particules (4) à l'entrée de cet étage de filtration (11), **caractérisé en ce qu'**un étage de filtration (11-13) est sélectionné avec un filtre dont l'effet peut être activé par application d'une tension électrique au filtre et/ou par envoi d'un courant électrique à travers le filtre, et **en ce que** l'efficacité (11a-13a) de l'étage de filtration est ajustée (320) par augmentation ou diminution de la tension électrique et/ou du courant électrique (322).

2. Procédé (300) selon la revendication 1, l'efficacité (11a-13a) de l'étage de filtration (11-13) étant ajustée (320) par augmentation ou diminution (321) de la section d'écoulement efficace d'une conduite de dérivation (15) contournant l'étage de filtration (11-13).

3. Procédé (100-300) selon l'une quelconque des revendications 1 à 2, la concentration actuelle n(d) de particules (4) à l'entrée de l'étage de filtration (11-13) étant déterminée (111) à partir d'une mesure de la concentration de particules (4) dans l'air ambiant de l'ensemble de filtration.

4. Procédé (100-300) selon l'une quelconque des revendications 1 à 3, une concentration actuelle et/ou attendue de particules (4) dans l'air ambiant de l'ensemble de filtration (1) provenant d'une source de données extérieure (112) et étant utilisée (113) pour déterminer la concentration actuelle et/ou attendue n(d) de particules (4) à l'entrée de l'étage de filtration (11-13).

5. Logiciel contenant des instructions lisibles par machine qui, lorsqu'elles sont exécutées sur un ordinateur et/ou sur une unité de commande et/ou sur un système embarqué, ordonnent à l'ordinateur, l'unité de commande et/ou le système embarqué de mettre en œuvre un procédé (100-300) sur l'ensemble de filtration selon l'une quelconque des revendications 1 à 4.
